Europäisches Patentamt

European Patent Office

Office européen des brevets

(19)

(11) Numéro de publication: **0 236 866**
**B1**

(12) **FASCICULE DE BREVET EUROPEEN**

(45) Date de publication du fascicule du brevet: **05.09.90**

(51) Int. Cl.⁵: **H 03 H 11/48**

(21) Numéro de dépôt: **87102752.0**

(22) Date de dépôt: **26.02.87**

(54) **Circuit multiplicateur de capacité, notamment pour joncteur électronique.**

(30) Priorité: **04.03.86 FR 8603015**

(43) Date de publication de la demande:
**16.09.87 Bulletin 87/38**

(45) Mention de la délivrance du brevet:
**05.09.90 Bulletin 90/36**

(84) Etats contractants désignés:
**BE CH DE ES FR GB IT LI NL SE**

(56) Documents cités:
**US-A-3 831 117**

**ARCHIV FÜR ELEKTRONIK UND
ÜBERTRAGUNGSTECHNIK, vol. 39, no. 2,
mars/avril 1985, pages 131-134, Stuttgart, DE;
P. VALTONEN: "Active-R simulation of
grounded reactances"**

**HEWLETT-PACKARD JOURNAL, vol. 25, no. 7,
mars 1974, pages 10-15, Palo Alto, US; G.
KRAUSS et al.: "A moderately priced 20-MHz
pulse generator with 16-volt output"**

(73) Titulaire: **ALCATEL CIT
12 Rue de la Baume
F-75008 Paris (FR)**

(72) Inventeur: **Albouy, Pierre
42, rue Georges Brassens
F-22300 Lannion (FR)**

(74) Mandataire: **Weinmiller, Jürgen
Lennéstrasse 9 Postfach 24
D-8133 Feldafing (DE)**

(56) Documents cités:
**PATENT ABSTRACTS OF JAPAN, vol. 2, no. 129,
27 octobre 1978, page 7753 E 78; & JP-A-53 95
553 (OKI DENKI KOGYO K.K.) 21-08-1978**

Courier Press, Leamington Spa, England.

## Description

L'invention concerne les joncteurs électroniques, qui assurent le couplage entre les lignes d'abonnés et un central téléphonique.

Les joncteurs d'abonnés doivent répondre à des spécifications précises notamment en ce qui concerne les impédances continue et alternative, et à cet effet les composantes continue et alternative du courant de ligne sont séparées.

Dans la demande de brevet français 2 527 404, joncteur d'abonné électronique, la séparation des composantes continue et alternative du courant de ligne est effectuée par un simple filtre du premier ordre. Les normes imposant un affaiblissement transhybride supérieur à 26dB à la fréquence de 300 Hz qui correspond à la borne basse de la bande de fréquence utilisée pour la transmission de la parole, cela conduit à utiliser un condensateur de forte valeur, de l'ordre de 30 microfarads, non polarisé. De plus il est nécessaire de connaître le courant traversant le condensateur.

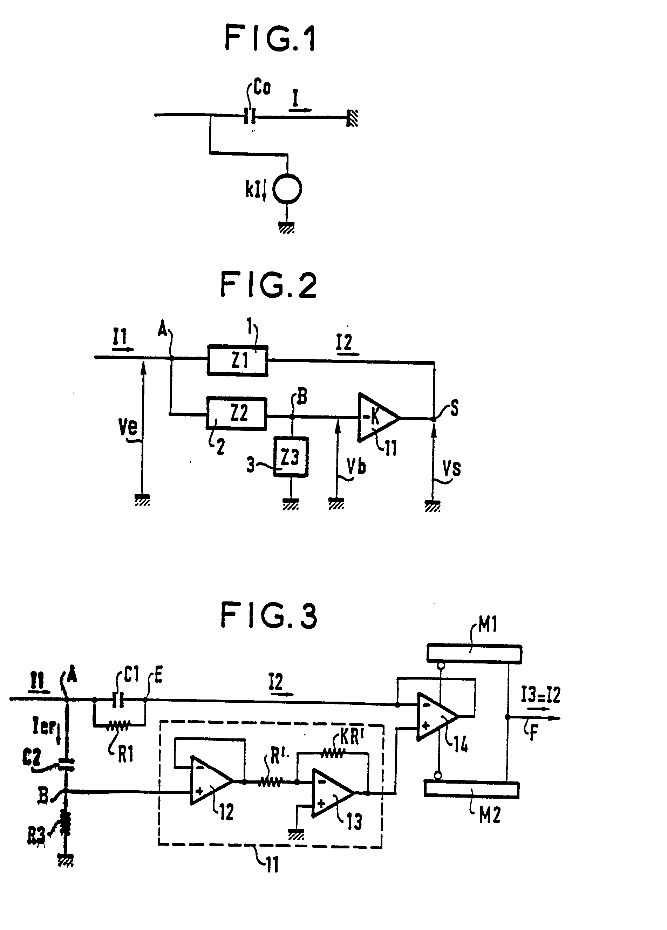

Le problème de la multiplication d'une capacité est classique et connu de l'homme de l'art, voir par exemple le document US—A—3831117; la figure 1 est un schema de principe, connu, d'un circuit multiplicateur faisant appel à une multiplication en courant, I étant le courant traversant le condensateur Co et k un facteur de multiplication.

L'impédance équivalente est

$$Z = \frac{1}{(k+1)\,Cop}\,,$$

avec $p = jw$ en notation symbolique, w étant la pulsation. On obtient bien ainsi un condensateur équivalent $(k+1)\,Co$, mais on n'a pas accès au courant qui traverse le condensateur.

L'invention a pour but la réalisation d'un circuit multiplicateur de capacité qui permette d'accéder au courant traversant le condensateur.

Un autre but de l'invention est la réalisation d'un circuit multiplicateur de capacité dans lequel le courant traversant le condensateur est égal a courant à l'entrée du circuit multiplicateur.

Un autre but de l'invention est la réalisation d'un circuit multiplicateur de capacité dans lequel le courant dans le condensateur est égal au courant à l'entrée du circuit multiplicateur et qui n'introduit pas de déphasage autre que 90° entre ledit courant et la tension à l'entrée du circuit multiplicateur.

Un autre but de l'invention est la réalisation d'un circuit multiplicateur de capacité pourvant supporter, dans la cas d'application à un joncteur électronique, une tension continue voisine des tensions d'alimentation du joncteur.

L'invention a pour objet un circuit multiplicateur de capacité caractérisé par le fait qu'il comporte entre une borne d'entrée et une borne de sortie un premier circuit constitué par un condensateur et une résistance en parallèle, et un deuxième circuit comportant une impédance capacitivee et une impédance résistive en série, et un circuit amplificateur, l'impédance capacite étant reliée à la borne d'entrée et l'impédance résistive étant reliée à la masse, le circuit amplificateur étant relié d'une part à un point commun à l'impédance capacitive et à l'impédance résistive, et d'autre part à la borne de sortie.

L'invention sera bien comprise par la description qui va suivre d'exemples de réalisation illustrés par les figures annexées dans lesquelles:

la figure 1 est un schéma de principe connu d'un circuit multiplicateur,
la figure 2 est un schéma électrique d'un circuit multiplicateur de l'invention,
la figure 3 représente un circuit électronique correspondant au schéma de la figure 2,
la figure 4 est un schéma électrique d'une variante du schéma de la figure 2,
la figure 5 représente un circuit électronique correspondant au schéma de la figure 4,
le figure 6 est un schéma d'une variante du schéma de la figure 2,
la figure 7 est un autre schéma du circuit multiplicateur de l'invention,
la figure 8 représente un circuit électronique utilisé dans la figure 7,
la figure 9 représente un circuit électronique correspondant au schéma de la figure 8,
la figure 10 représente une application du circuit multiplicateur de la figure 9 à un joncteur.

La figure 2 est un schéma d'un circuit multiplicateur d'impédance capacitive de l'invention, constitué par trois circuits 1, 2, 3 d'impédances Z1, Z2, Z3 et un circuit amplificateur 11 de gain — K.

Les circuits 2 et 3 sont en série entre une borne d'entrée A et la masse. Le circuit amplificateur 11 est relié d'une part à la borne B et d'autre part au circuit 1. Il est le courant appliqué à la borne d'entrée A et I2 est le courant qui traverse le circuit 1; Ve est la tension d'entrée, entre la borne d'entrée A et la masse, Vb est la tension entre la borne B et la masse, c'est donc la tension à l'entrée du circuit amplificateur 11, Vo étant la tension de sortie du circuit amplificateur 11, entre une borne de sortie S et la masse. On a les relations suivantes:

$$Vb = \frac{Ve\,Z3}{Z2+Z3} \qquad Vo = -K\,Vb = -Ve\,\frac{KZ3}{Z2+Z3} \qquad I2 = \frac{Ve-Vo}{Z1} = \frac{Ve}{Z1}\left(1+\frac{K\,Z3}{Z2+Z3}\right) \qquad (1)$$

2

$$I1 = I2 + \frac{Ve}{Z2 + Z3} = Ve\left(\frac{1}{Z1} + \frac{K\frac{Z3}{Z1} + 1}{Z2 + Z3}\right) \quad I1 = \frac{Ve}{Z1}\left(\frac{Z1 + Z2 + (K+1)\,Z3}{Z2 + Z3}\right) \quad (2)$$

Si l'on identifie le courant I2 à celui obtenu dans le cas d'un circuit parallèle constitué par un condensateur de valeur Cr et d'une résistance de valeur Rr on à:

$$I2 = \frac{Ve}{Rr}(Rr\,Crp + 1) \quad (3)$$

On est amené à avoir des circuits 1, 2, 3 constitués comme suit:
le circuit 1 est constitué par un condensateur C1 en parallèle sur une résistance $R_1$ ce qui donne

$$Z1 = \frac{R1}{R1C1p+1}$$

le circuit 2 est constitué par un condensateur C2 ce qui donne

$$Z2 = \frac{1}{C2p}$$

Z3 est constituée par une résistance R3, donc Z3 =R3.
Avec les valeurs de Z1, Z2, Z3 indiquées ci-dessus l'équation (1) divient

$$I2 = \frac{Ve}{R1}(R1C1p+1)\left(1 + \frac{K\,R3}{1 + \frac{R3}{C2p}}\right) = \frac{Ve}{R1}(R1C1p+1)\left(\frac{R3C2p + 1 + KR3C2p}{R3C2p + 1}\right)$$

en faisant R1C1 = R3 C2 il vient:

$$I2 = \frac{Ve}{R1}(1 + (K+1)\,R1C1p) \quad (4)$$

Le courant I1 est égal à:

$$I1 = I2 + \frac{Ve}{Z2 + Z3} = \frac{Ve}{R1}(1 + (K+1)R1C1p) + \frac{Ve}{\frac{1}{C2p} + R3} \quad (5)$$

L'équation (4) du courant I2 est identique à l'équation (3), de sorte que le courant I2 de l'équation (4) est celui qui traverserait un circuit constitué par un condensateur (K+1) C1 en parallèle sur une résistance R1. Le circuit multiplicateur de la figure 2 est donc équivalent, en ce qui concerne le courant I2, à un condensateur (K+1) C1 en parallèle sur une résistance R1; ceci par contre n'est pas vrai pour le courant I1, équation (5) qui diffère du courant I2 de la valeur:

$$I\,er = \frac{Ve\,C2p}{R3\,C2p + 1}$$

qui peut être rendue très petite en prenant une résistance R3 très grande.
De ce qui précède, il résulte que le circuit électronique correspondant au schéma de la figure 2 est celui représenté figure 3 dans laquelle le circuit amplificateur 11 comporte un amplificateur opérationnel 12 ayant une entrée positive reliée à la borne B et sa sortie reliée à une entrée négative, un résistance R' reliant la sortie de l'amplificateur opérationnel 12 à une entrée négative d'un autre amplificateur opérationnel 13 ayant une entrée positive reliée à la masse et sa sortie reliée par une résistance KR' à son entrée négative. Afin d'accéder au courant I2, un amplificateur opérationnel de sortie 14 a une entrée négative reliée d'une part à sa sortie et d'autre part à une borne E commune au condensateur C1 et à la résistance R1, et une entrée positive reliée à la sortie de l'amplificateur opérationnel 13. L'amplificateur de sortie 14 est relié à une entrée de deux miroirs de courant M1 et M2, reliés en sortie à un fil F auquel il délivrent un courant I3, ce courant étant égal au courant I2 traversant le circuit parallèle constitué par le condensateur C1 et la résistance R1.

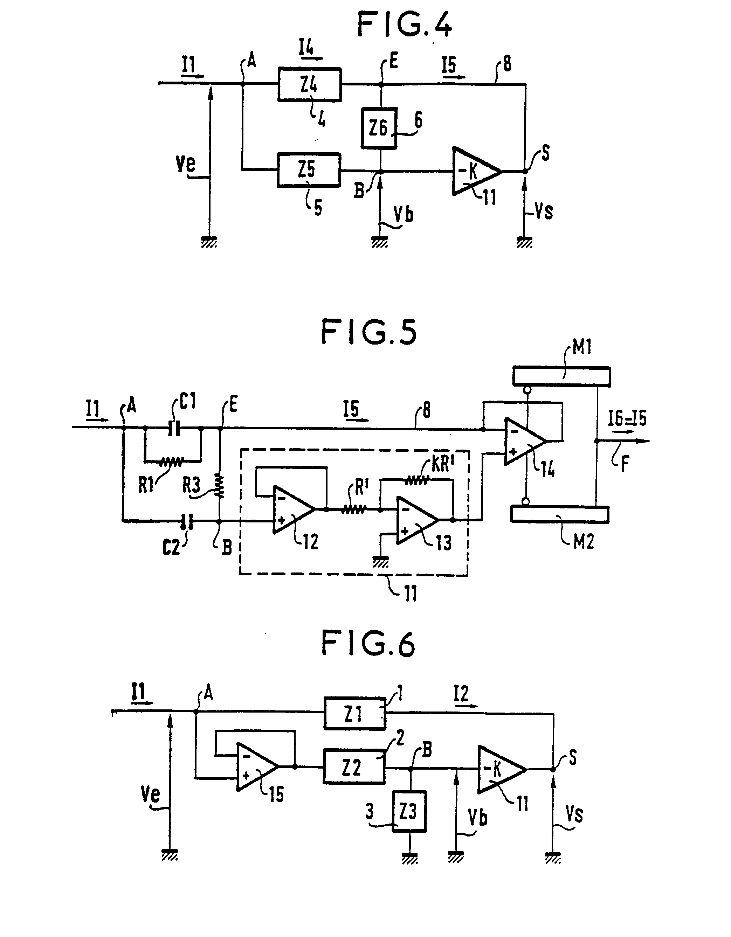

La figure 4 est un schéma d'une variante du circuit multiplicateur d'impédance capacitive de l'invention, qui est constitué par trois circuits 4, 5, 6 d'impédances Z4, Z5, Z6 et un circuit amplificateur 11 de gain −K. Le circuit 4 est relié à la borne d'entrée A du circuit multiplicateur et à une borne E; le circuit 5 est relié à la borne d'entrée A et à une borne B; le circuit 6 et le circuit amplificateur 11 sont reliés en parallèle aux bornes B et E. Ve est la tension d'entrée entre la borne d'entrée A et la masse, Vb est la tension entre la borne B et la masse, Vs est la tension en sortie du circuit amplificateur 11, I1 est le courant appliqué à la borne d'entrée A et I5 est le courant dans la liaison 8 reliant la borne E à la sortie S du circuit amplificateur 11. Dans la cas de la figure 4 les courants I1 et I5 sont égaux; on a donc I = I1 = I5, et

$$I = \frac{Ve - Vs}{Z4} + \frac{Ve - Vs}{Z5 + Z6} = (Ve-Vs) \left( \frac{1}{Z4} + \frac{1}{Z5 + Z6} \right) \tag{7}$$

On remarquera que le terme

$$\frac{Ve - Vs}{Z4}$$

est égal au courant I4 dans le circuit 4, puisque la tension au point E est égale à Vs.

La tension Vb, au point B est donnée par l'éaquation:

$$Vb = \frac{VeZ6 + VsZ5}{Z5 + Z6} \tag{8}$$

La tension Vs en sortie du circuit amplificateur 1 est Vs = −KVb; en reportant la valeur de VB donnée par l'équation (8) il vient:

$$Vs = - \frac{K \, Ve \, Z6}{Z5 + Z6} - \frac{K \, Vs \, Z5}{Z5 + Z6} \tag{9}$$

d'où:

$$Vs \left( 1 + \frac{K \, Z5}{Z5 + Z6} \right) = - \frac{K \, Ve \, Z6}{Z5 + Z6} \tag{10}$$

et:

$$Vs = - Ve \frac{K \, Z6}{(K+1) \, Z5 + Z6} \tag{11}$$

En reportant la valeur de Vs dans l'équation (7) on obtient:

$$I = Ve \left( 1 + \frac{K \, Z6}{(K+1) \, Z5 + Z6} \right) \left( \frac{1}{Z4} + \frac{1}{Z5 + Z6} \right)$$

ce qui donne:

$$I = Ve \left[ \frac{(K+1)(Z5 + Z6)}{(K+1) \, Z5 + Z6} \right] \left[ \frac{Z4 + Z5 + Z6}{Z4 \, (Z5 + Z6)} \right]$$

d'où:

$$I = \frac{Ve}{Z4} \left[ \frac{Z4 + Z5 + Z6}{\dfrac{Z5 + Z6}{K+1}} \right] \tag{12}$$

En ayant le circuit 4 constitué par un circuit parallèle constitué par un condensateur C1 et une résistance R1 ce qui donne

$$Z4 = \frac{R1}{R1\,C1p + 1} \, ,$$

le circuit 5 constitué par un condensateur C2 ce qui donne

$$Z5 = \frac{1}{C2p}$$

et un circuit 6 constitué par une résistance R3, ce qui donne Z6 = R3, et en remplaçant dans l'équation (12) les impédances Z4, Z5, Z6 par leurs valeurs, il vient:

$$I = \frac{Ve}{R1}\,(R1C1p+1) \left[ \frac{\dfrac{R1}{R1C1p+1} + \dfrac{1}{C2p} + R3}{\dfrac{1}{C2p} + \dfrac{R3}{(K+1)}} \right]$$

et:

$$I = \frac{Ve}{R1}\,(R1C1p+1) \left[ \frac{\dfrac{R1C2p}{R1C1p+1} + 1 + R3C2p}{\dfrac{R3C2p}{K+1} + 1} \right] \qquad (13)$$

En prenant $R1C1 = \dfrac{R3C2}{K+1}$; l'équation (13) devient:

$$I = \frac{Ve}{R1} \left[ \frac{R1C2p}{R1C1p+1} + 1 + (K+1)\,R1C1p \right] \qquad (14)$$

On a indiqué que l'on avait

$$I4 = \frac{Ve - Vs}{Z4} \, ;$$

en reportant dans cette équation la valeur de Vs donnée par l'équation (11) on obtient, en remplaçant les impédances Z4, Z5, Z6 par leurs valeurs:

$$I4 = \frac{Ve}{R1}\,(R1C1p+1) \left[ \frac{1 + R3C2p}{\dfrac{1 + R3C2p}{K+1}} \right]$$

pet en prenant $R1C1 = \dfrac{R3C2}{K+1}$ il vient:

$$I4 = \frac{Ve}{R1}\,(1 + (K+1)\,R1C1p) \qquad (15)$$

Le courant I4 est égal au courant qui passerait dans un circuit constitué par un condensateur (K+1) C1 en parallèle avec une résistance R1.

Dans l'equation (14) le terme

$$\frac{Ve}{R1}(1 + (K+1)\ R1C1p)\ \text{est égal au courant 14 de l'équation (15)}$$

On a donc

$$I = I4 + \frac{Ve\ C2p}{R1C1p+1}$$

équation dans laquelle le deuxième terme est d'autant plus petit que C2 est plus petit, c'est-à-dire, en tenant compte de l'équation

$$R1\ C1 = \frac{R3\ C2}{K + 1},$$

que la résistance R3 est grande; on retrouve la même condition que précédemment.

Le circuit é1uivalent au schéma de la figure 4 est représenté figure 5. Le circuit ne différe du circuit de la figure 3 que par le branchement de la résistance R3 entre les bornes B et E; le courant I6 délivré par les miroirs de courant M1 et M2 est égal au courant I5.

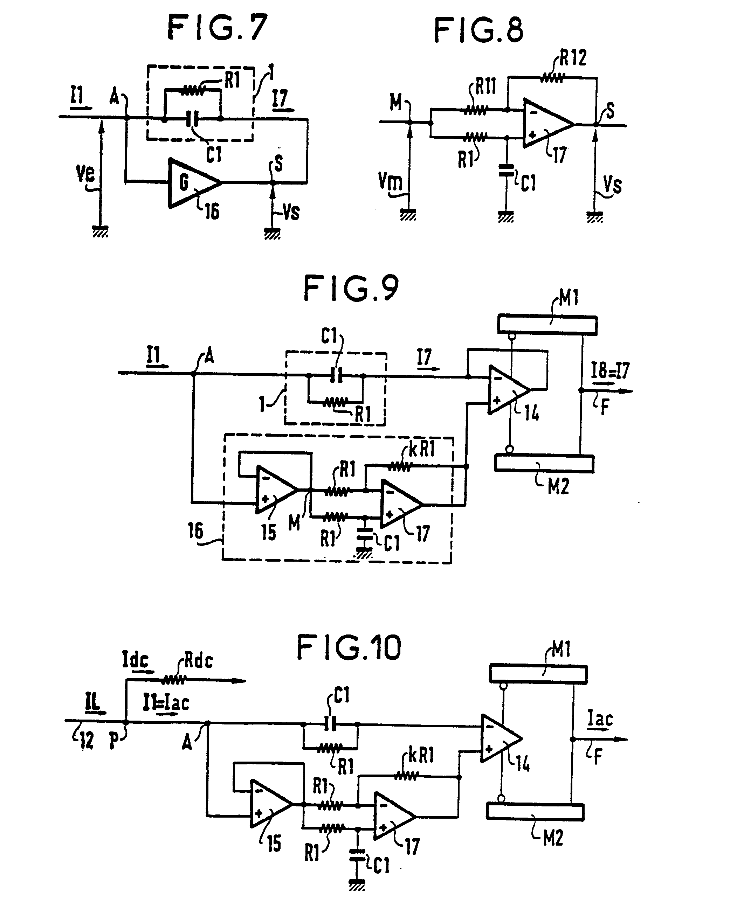

La figure 6 est un schéma d'une variante du circuit multiplicateur de la figure 2, dans lauqelle ou utilise un amplificateur opérationnel 15 monté en suiveur, entre la borne d'entrée A et la circuit 2; de cette manière on s'affranchit du terme parasite dans l'équation (5) du courant I1, de sorte que l'on obtient I1 = I2, ce qui est un des buts de l'invention.

$$I1 = I2 = \frac{Ve}{R1}(1 + (K+1)\ R1C1p)$$

Dans les variantes décrites ci-dessus, figures 2, 4 et 6 le courant I2, ou I4, correspond à celui qui traverserait un circuit constitué par un condensateur de valeur (K+1) C1 en parallèle sur une résistance R1.

Dans ces trois variantes le déphasage entre tension et courant, produit par la circuit parallèle R1, C1, varie entre 0 et π/2; en haute fréquence, lorsque le gain −K du circuit amplifacateur 11 diminue, la capacité du condensateur équivalent tend vers C1.

La figure 7 est un schéma d'une quatrième variante du circuit multiplicateur de l'invention, constitué par le circuit 1 d'impédance Z1 et un circuit amplificateur 16 de gain G en parallèle sur le circuit 1, lui même constitué par un condensateur C1 en parallèle avec une résistance R1. Ce shéma se déduit de celui de la figure 2 en prenant Z2 = 0 et Z3 infinie.

Dans ces conditions les courants I1 et I7 sont égaux, I7 étant dans la figure 7 le courant dans le circuit 1. On a donc:

$$I1 = I7 = \frac{Ve\ (1-G)}{Z1}$$

En remplaçant Z1 par sa valeur $Z1 =$

$$\frac{R1}{R1C1p+1}$$

il vient:

$$I1 = I7 = \frac{Ve(1-G)(R1C1p+1)}{R1} \tag{16}$$

Pour obtenir un condensateur équivalent sans résistance en parallèle il faut avoir des courants de la forme:

$$I1 = I7 = Ve\ (k+1)\ C1p \tag{17}$$

6

EP 0 236 866 B1

équation dans laquelle k est un coefficient.

En égalant les équation (16) et (17), on obtient:

$$G = 1 - \frac{(k+1)\ R1C1p}{R1C1p+1}$$

soit:

$$G = \frac{1 - kR1C1p}{1 + R1C1p} \tag{18}$$

La synthèse de l'équation de transfert (18) est aisée, et représentée figure 8 dans laquelle un amplificateur opérationnel 17 a une entrée positive reliée d'une part à la masse par un condensateur C1 et d'autre part à un point M par une résistance R1, et une entrée négative reliée d'une part au point M par une résistance R11 et à sa sortie S par une résistance R12. Entre les tensions Vm au point M et Vs au point S on a la relation:

$$G = \frac{Vm}{Vs} = \frac{1 - \dfrac{R12\ R1\ C1p}{R11}}{1 + R1\ C1p} \tag{19}$$

$$\text{En prenant } \frac{R12}{R11} = k \tag{20}$$

on obtient bien la fonction de transfert donnée par l'equation (18), et le condensateur é1uivalent donné par le schéma de la figure 7 a la valeur (k+1) C1p de l'équation (17) dans laquelle k est donné par la relation (20).

La figure 9 représente la circuit électronique équivalent au schèma de la figure 7 dans laquelle le circuit amplificateur 16 est constitué par un amplificateur 15 et le circuit de la figure 8, l'amplificateur 15 de gain unité étant connecté entre la borne d'entrée A et le point M du circuit amplificateur 16, ceci pour satisfaire à la double condition Z2 = 0 et Z3 infinie indiqué ci-dessus, et avoir I1 = I7. L'amplificateur 15 a une entrée positive reliée à la borne d'entrée A, une entrée négative reliée au point M et une sortie reliée au point M.

Dans cette figure 9 les résistances R11 et R12 de la figure 8 ont les valeurs R1 et kR1, respectivement, ce qui respecte bien la relation (20) et ne modifie pas l'équation (19) dans laquelle les résistances R11 et R12 interviennent par leur rapport k.

Avec le circuit multiplicateur de la figure 9, le condensateur équivalent (k+1) C1 ne comporte pas de résistance en parallèle et l'on a bien I1 = I7, conformément aux buts de l'invetion. Le circuit de la figure 9 n'introduit donc pas de déphasage entre le tension d'entrée Ve et le courant I7.

L'amplificateur opérationnel de sortie 14, de gain unité, a une entrée négative reliée au circuit 1 et une entrée positive reliée à la sortie du circuit 16, c'est-à-dire à la sortie de l'amplificateur 17. Les miroirs de courants M1 et M2 délivrent un courant I8 égal au courant I7; comme celui-ci est égal à I1 on a I8 = I1.

La figure 10 représente l'application à un joncteur électronique. Dans cette figure on retrouve le circuit multiplicateur de la figure 9, dont la borne d'entrée A est reliée à une borne P eille même reliée à un fil 12 parcouru par un courant IL égal au courant de ligne d'abonné ce courant de ligne ayant une composante continue Idc et une composante alternative Iac; on a donc IL = Idc + Iac. Une résistance Rdc est reliée au point P; elle est parcourue par la composante continue Idc. La composante alternative Iac traverse le circuit multiplicateur de capacité, ce circuit se comportant comme un condensateur de valeur (k+1) C; on a donc I1 = Iac. Le circuit de la figure 10 réalise donc, dans le joncteur électronique, la séparation des composantes continue et alternative du courant de ligne IL; cette séparation est en effet nécessaire dans tout joncteur, afin de traiter séparément les signaux de parole et la composante continue du courant de ligne, cette dernière servant notamment pour la détection de boucle.

Les circuits multiplicateurs de capacité des figures 3, 5 et 9 peuvent être aisément réalisés sous la forme d'un circuit intégré. Ainsi dans le cas de la figure 9 avec un coefficient k = 20 le condensateur équivalent est 21 C1; un condensateur équivalent de capacité 30 microfarads s'obtient avec un condensateur C1 de capacité 1,5 microfarad.

Le circuit multiplicateur de capacité de la figure 9 présente l'avantage d'être équivalent à un condensateur sans résistance en parallèle, et par conséquent d'avoir un comportement en phase idéal; de plus dans le cas de l'application à un joncteur, la tension continue dans ce circuit n'est nulle part plus grande que la tension continue à l'entrée du circuit.

7

# EP 0 236 866 B1

## Revendications

1. Circuit multiplicateur de capacité caractérisé par le fait qu'il comporte entre une borne d'éntrée (A) et une borne de sortie (S) un premier circuit (1) constitué par un condensateur (C1) et une résistance (R1) en parallèle, et un deuxième circuit comportant une impédance capacitive (2) et une impédance résistive (3) en série, et un circuit amplificateur (11), l'impédance capacitive étant reliée à la borne d'entrée et l'impédance résistive étant reliée à la masse, le circuit amplificateur étant relié d'une part à un point commun (B) à l'impédance capacitive et à l'impédance résistive, et d'autre part à la borne de sortie (S).

2. Circuit multiplicateur selon la revendication 1, caractérisé par le fait qu'un amplificateur de gain unite (15) est connecté entre la borne d'entrée (A) et l'impédance capacitive.

3. Circuit multiplicateur selon l'une des revendications 1 et 2, caractérisé par le fait que le circuit amplificateur comprend un premier (12) et un deuxième (13) amplifcateurs, le premier amplificateur ayant un gain unité et étant relié en entrée audit point commun (B) à l'impédance capacitive et à l'impédance résistive, et une sortie reliée par une première résistance (R') à une entrée négative du deuxième amplificateur (13), ledit deuxième amplificateur ayant une sortie reliée par une deuxième résistance (KR') à son entrée négative et une entrée positive reliée à la masse.

4. Circuit multiplicateur selon la revendication 1, caractérisé par le fait que le deuxième circuit a une impédance capacitive de valeur nulle, une impédance résistive de valeur infinie, et un circuit amplificateur constitué par un premier amplificateur (15), de gain unité, et un deuxième amplificateur (17) ayant une entrée positive reliée d'une part en sortie du premier amplificateur par une première résistance (R1) et d'autre part à la masse par un condensateur (C1), une entrée négative reliée d'une part en sortie du premier amplificateur par une deuxième résistance (R11) et d'autre part à une sortie du deuxième amplificateur par une troisième résistance (R12), la première résistance et le condensateur ayant mêmes valeurs que la résistance et le condensateur du premier circuit (1), et que la troisième résistance (R12)) a une valeur égale à cell de la deuxième résistance (R11) multipliée par un coefficient k.

5. Circuit multiplicateur selon la revendication 4, caractérisé par le fait que la deuxième résistance ($R_{11}$) a même valeur que la première résistance (R1).

6. Circuit multiplicateur selon la revendication 1, caractérisé par le fait que les premier et deuxième circuits sont connectés en parallèle par l'intermédiaire d'un amplificateur de sortie (14), le premier circuit (1) étant connecté entre la borne d'entrée (A) et une entrée négative de l'amplificateur de sortie, le deuxième circuit étant connecté entre la borne d'entrée (A) et une entrée positive dudit amplificateur de sortie, et que ledit amplificateur de sortie est relié en sortie à une entrée d'un premier (M1) et d'un deuxième (M2) miroirs de courant, lesdits miroirs de courant étant reliés en sortie.

## Patentansprüche

1. Schaltungsanordung zur Kapazitätsmultiplikation, dadurch gekennzeichnet, daß sie zwischen einer Eingangsklemme (A) und einer Ausgangsklemme (S) einen ersten aus der Parallelschaltung eines Kondensators (C1) und eines Widerstands (R1) bestehenden Kreis (1) und einen zweiten aus einer Serienschaltung einer kapazitaven (2) und einer ohm'schen Impedanz (3) und aus einem Verstärkerkreis (11) bestehenden zweiten Kreis aufweist, wobei die kapazitive Impedanz an die Eingangsklemme und die ohm'sche Impedanz an Masse angeschlossen ist, und daß der Verstärkerkreis einerseits an einen Verbindungspunkt (B) zwischen der kapazitiven und der ohm'schen Impedanz und andererseits an die Ausgangsklemme (S) angeschlossen ist.

2. Schaltungsanordnung nach Anspruch 1, dadurch gekennzeichnet, daß ein Verstärker (15) mit Einheitsverstärkung zwischen die Eingangsklemme (A) und die kapazitive Impedanz eingefügt ist.

3. Schaltungsanordnung nach einem der Ansprüche 1 und 2, dadurch gekennzeichnet, daß der Verstärkerkreis einen ersten (12) und einen zweiten Verstärker (13) aufweist, wobei der erste Verstärker mit Einheitsverstärkung arbeitet und eingangsseitig an den Verbindungspunkt (B) zwischen der kapazitiven und der ohm'schen Impedanz und ausgangsseitig über einen ersten Widerstand (R') an einen negativen Eingang des zweiten Verstärkers (13) angeschlossen ist, während der Ausgang des zweiten Verstärkers über einen zweiten Widerstand (KR') an seinen eigenen negativen Eingang rückgekoppelt ist, während sein positiver Eingang an Masse liegt.

4. Schaltungsanordnung nach Anspruch 1, dadurch gekennzeichnet, daß der zweite Kreis eine kapazitive Impedanz des Werts Null, eine ohm'sche Impedanz des Werts Unendlich und einen Verstärkerkreis aufweist, der von einem ersten Verstärker (15) mit Einheitsverstärkung und einem zweiten Verstärker (17) gebildet wird, dessen positiver Eingang einerseits mit dem Ausgang des ersten Verstärkers über einen ersten Widerstand (R1) und andererseits über einen Kondensator (C1) mit Masse verbunden ist, und dessen negativer Eingang einerseits mit dem Ausgang des ersten Verstärkers über einen zweiten Widerstand (R11) und andererseits mit einem Ausgang des zweiten Verstärkers über einen dritten Widerstand (R12) verbunden ist, wobei der erste Widerstand und der Kondensator dieselben Werte wie der Widerstand und der Kondensator des ersten Kreises (1) aufweisen, und daß der dritte Widerstand (R12) den k-fachen Wert des zweiten Widerstands (R11) besitzt.

5. Schaltungsanordnung nach Anspruch 4, dadurch gekennzeichnet, daß der zweite Widerstand (R11) denselben Wert wie der erste Widerstand (R1) besitzt.

# EP 0 236 866 B1

6. Schaltungsanordnung nach Anspruch 1, dadurch gekennzeichnet, daß der erste Kreis zum zweiten Kreis über einen Ausgangsverstärker (14) parallelgeschaltet ist, derart, daß der erste Kreis (1) zwischen der Eingangsklemme (A) und einem negativen Eingang des Ausgangsverstärkers liegt, daß der zweite Kreis zwischen der Eingangsklemme (A) und einem positiven Eingang des Ausgangsverstärkers liegt und daß der Ausgangsverstärker ausgangsseitig an je einen Eingang eines ersten (M1) und eines zweiten Stromspiegels (M2) angeschlossen ist, die ausgangsseitig miteinander verbunden sind.

## Claims

1. A capacitance-multiplying circuit characterized by the fact that it comprises, between an input terminal (A) and an output terminal (S), a first circuit (1) constituted by a parallel connected capacitor (C1) and resistor (R1) and a second circuit constituted by a series connected capacitive impedance (2) and resistive impedance (3), and an amplifier (11), the capacitive impedance being connected to the input terminal and the resistive impedance being connected to ground, the amplifier circuit being connected firstly to a point (B) common to the capacitive impedance and to the resistive impedance, and secondly to the output terminal (S).

2. A capacitance-multiplying circuit according to claim 1, characterized by the fact that a unit gain amplifier (15) is connected between the input terminal (A) and the capacitive impedance.

3. A capacitance-multiplying circuit according to claim 1 or 2, characterized by the fact that the amplifier circuit comprises first and second amplifiers (12, 13), the first amplifier having unit gain and having its input connected to said common point (B) between the capacitance impedance and the resistive impedance, and an output connected via a first resistor (R') to a negative input of the second amplifier (13), the said second amplifier having an output connected via a second resistor (KR') at its negative input and a positive input connected to ground.

4. A capacitance-multiplying circuit according to claim 1, characterized by the fact that the second circuit has a capacitance inpedance whose value is zero, a resistive impedance whose value is infinite, and an amplifier circuit constituted by a first amplifier (15) of unit gain and a second amplifier (17) having a positive input connected firstly to the output of the first amplifier via a first resistor (R1) and secondly to ground via a capacitor (C1), a negative input connected firstly to the output of the first amplifier via a second resistor (R11) and secondly to an output of a second amplifier via a third resistor (R12), the first resistor and the capacitor having the same values as the resistor and the capacitor of the first circuit (1), and that the third resistor (R12) has a value equal to the value of the second resistor (R11) multiplied by a coefficient $k$.

5. A capacitance-multiplying circuit according to claim 4, characterized by the fact that the second resistor (R11) has the same value as the first resistor (R1).

6. A capacitance-multiplying circuit according to claim 1, characterized by the fact that the first and second circuits are connected in parallel by means of an output amplifier (14), the first circuit (1) being connected between the input terminal (A) and a negative input of the output amplifier, the second circuit being connected between the input terminal (A) and a positive input of said output amplifier, and that the output amplifier has its output connected to an input of first and second current mirrors (M1, M2), the outputs of the current mirrors being connected together.

# FIG.1

# FIG.2

# FIG.3

1

# FIG.4

# FIG.5

# FIG.6

# FIG.7

# FIG.8

# FIG.9

# FIG.10